# EUROPÄISCHE PATENTSCHRIFT

(11) **EP 4 192 899 B1**
(45) Veröffentlichungstag und Bekanntmachung des Hinweises auf die Patenterteilung: **21.05.2025**
(21) Anmeldenummer: 21763278.5
(22) Anmeldetag: 10.08.2021
(51) Int. Cl.: C08G 61/12, B01J 13/18, C08L 65/00, C09C 3/10, C09K 11/06

(54) **VERFAHREN ZUR HERSTELLUNG LEITFÄHIGER PEDOT:PSS-PARTIKEL**
METHOD FOR PRODUCING CONDUCTIVE PEDOT:PSS PARTICLES
PROCÉDÉ DE FABRICATION DE PARTICULES PEDOT:PSS CONDUCTRICES

(30) Priorität: 10.08.2020 DE 102020121036
(43) Veröffentlichungstag der Anmeldung: 14.06.2023
(73) Patentinhaber: Rheinisch-Westfälische Technische Hochschule (RWTH) Aachen, 52062 Aachen (DE)
(72) Erfinder: RAUER, Sebastian Bernhard, 52074 Aachen (DE); BELL, Daniel Josef, 52477 Alsdorf (DE); WESSLING, Matthias, 52074 Aachen (DE)
(74) Vertreter: Michalski Hüttermann & Partner Patentanwälte mbB
(86) Internationale Anmeldenummer: PCT/EP2021/072276
(87) Internationale Veröffentlichungsnummer: WO 2022/034082

(56) Entgegenhaltungen:
- WO-A1-2013/148307
- CN-A- 106 381 571
- CN-A- 106 914 197
- US-A1- 2016 064 672
- US-A1- 2018 094 119

## Beschreibung

Die vorliegende Erfindung betrifft ein Verfahren zur Herstellung von Poly(3,4-ethylendioxy-thiophen):Polystyrolsulfonat (PEDOT:PSS) Partikeln mindestens umfassend die Schritte:
a) Bereitstellen einer Mischung umfassend Poly(3,4-ethylendioxythiophen) und Polystyrol-sulfonat in einem Lösemittel mindestens umfassend Wasser;
b) Ausbilden eines oder mehrerer PEDOT:PSS-Tropfen durch Einbringen der Mischung aus Verfahrensschritt a) in ein organisches Lösemittel A, wobei die wässrige PEDOT:PSS-Mischung das Tropfeninnere und das organische Lösungsmittel A das Tropfenäußere ausbilden;
c) Kontaktieren der PEDOT:PSS-Tropfen erhalten aus Verfahrensschritt b) mit einer Koagulierlösung umfassend ein Aushärtungsmittel und mindestens ein weiteres Lösungsmittel B, wobei die Dichte der Koagulierlösung größer als die Dichte des organischen Lösemittels A und kleiner als die Dichte der wässrigen Poly(3,4-ethylendioxythiophen) und Polystyrolsulfonat-Mischung ist; unter Aushärten der PEDOT:PSS-Tropfen zu PEDOT:PSS-Partikeln. Des Weiteren offenbart die vorliegende Erfindung sphärische PEDOT:PSS-Partikel ohne weitere mechanisch verfestigende Substanzen sowie die Verwendung der Partikel beispielsweise als Zellkultur-Mikroträgem oder Suspensionselektroden.

In vielen Industriezweigen, beispielsweise der Nahrungsmittel-, Kosmetik- oder der pharmazeutischen Industrie, werden große Mengen komplexer biologischer Substanzen benötigt. Üblicherweise werden diese Substanzen meist in Rührkesselreaktoren mit Hilfe von Zellkulturen hergestellt. Da die meisten Wirbeltierzellen adhärente Zellen, d.h. auf Substrate zum Wachsen und Proliferieren angewiesen, sind, wird üblicherweise das Kulturmedium um biokompatible Trägerpartikel ergänzt. Poly(3,4-ethylendioxythiophen):Polystyrolsulfonat-(PEDOT:PSS)-Partikel kommen hier bevorzugt zum Einsatz, da die Ausdehnung dieser Partikel im richtigen Mikrometer-Größenbereich liegt, die Oberflächenstruktur eine Verankerung der Zellen auf der Partikeloberfläche begünstigt, die Partikeldichte die Suspension der Partikel im Rührkesselreaktor bei niedrigem Energieeintrag erlaubt und die Partikel zudem biologisch kompatibel sind. PEDOT:PSS-Partikel bieten aufgrund ihrer spezifischen Porosität zudem ein sehr hohes Oberflächen-zu-Volumen-Verhältnis, welches die Grundlage für eine effiziente Großproduktion biologischer Substanzen liefert. Des Weiteren weist PEDOT:PSS als Materialsystem auch besondere elektrische Eigenschaften auf. Die Partikel können sehr schnelle Ladungs-/Entladungskinetiken und hohe Energie- und Leistungsdichten bereitstellen, da die elektrische Ladung nicht nur in der elektronischen Doppelschicht sondern auch innerhalb der Polymermatrix gespeichert wird. Diese Grundeigenschaften führen dazu, dass die Partikel erfolgsversprechende Substrate auch in der Energiespeicher- und Energieumwandlungstechnik darstellen.

Nachteiliger Weise sind bis dato gefüllte oder poröse PEDOT:PSS Partikel nur in Kombination mit einem Verbund- oder Trägerstoff herstellbar, welcher den Partikeln eine intrinsisch fehlende, mechanisch unterstützende sowie auch formgebende Eigenschaften verleiht. Zur Synthese dieser stabilisierten Partikel sind komplexe, mehrschrittige Verfahrensschritte nötig, welche nur ungenügende Voraussetzungen zur effizienten Maßstabsvergrößerung bieten und im Falle von Hybridpartikeln aufgrund des elektrisch inaktiven Zusatzmaterials zu einer Verschlechterung der elektrochemischen Eigenschaften der Partikel führen. Darüber hinaus existiert keine Verfahren und dementsprechend auch keine kommerziell erhältlichen Mikroträger, welche auf Basis nur eines, vollständig synthetischen Hydrogels hergestellt werden.

In der Patentliteratur finden sich einige Ansätze zu PEDOT:PSS-Mikropartikeln.

So beschreibt beispielsweise die EP 28 311 83 B1 ein Verbundstoffteilchen, das Folgendes umfasst: einen einzelnen Kugelkern, der mindestens ein anorganisches Oxid umfasst, und eine Polymerschicht, die auf dem Kugelkern angeordnet ist und diesen abgrenzt, wobei die Polymerschicht ein kationisches Polymer und ein anionisches Polymer umfasst.

Des Weiteren offenbart die EP 01 953 81 B1 einen Verbundwerkstoff aus porösen Werkstoffen und elektrisch leitfähigen Polymeren, wobei die Oberflächen der Poren zunächst mit einer Schicht aus einem elektrisch leitfähigen Polymeren beschichtet sind, das durch Behandeln der Monomeren mit einem Oxidationsmittel erhalten wurde, und darauf eine Schicht aus einem elektrisch leitfähigen Polymeren aufgebracht ist, die durch anodische Oxidation der Monomeren erhalten wurde.

In einem weiteren Patentdokument, der CN 110 233 061 A, wird ein Herstellungsverfahren eines porösen flexiblen PEDOT: PSS-Films mit hoher Leitfähigkeit offenbart. Gemäß des Verfahrens werden Polystyrol-Nanokugeln als Matrizen verwendet; PEDOT:PSS-Dispersionsflüssigkeit und die Polystyrol-Nanokugeln werden in situ gemischt; Ein poröser PEDOT:PSS-Film wird durch Vakuumsaugfiltration erhalten. Die Leitfähigkeit des Films wird durch Lösungsmittelnachbehandlung optimiert. Der hergestellte PEDOT:PSS-Film hat eine poröse Struktur, zeigt ausgezeichnete elektrochemische Eigenschaften wie relativ hohe Leitfähigkeit, hohe Ladungsentladungsstabilität, hohe Ratenleistung und dergleichen, kann für eine Hochleistungsfilmelektrode oder Hochleistungsfilmkondensator verwendet werden.

Weitere Verfahren zur Herstellung von Partikeln sind beispielsweise in der CN 108 381 571 A, US 2018/094119 A1, CN 106 914197 A, WO 2018/148807 A1 und der US 2016/064672 A1 beschrieben.

Derartige aus dem Stand der Technik bekannte Lösungen können noch weiteres Verbesserungspotential bieten, insbesondere hinsichtlich der Einfachheit des Herstellungsverfahrens, der Reproduzierbarkeit sowie der Gleichmäßigkeit der über das Verfahren herstellbaren Partikel.

Es ist daher die Aufgabe der vorliegenden Erfindung, die aus dem Stand der Technik bekannten Nachteile zumindest teilweise zu überwinden. Es ist insbesondere die Aufgabe der vorliegenden ein einfaches und reproduzierbares Herstellverfahren zu offenbaren, welches leicht upscalingfähig ist und innerhalb kurzer Prozesszeiten hoch genau definierte PEDOT-PSS Partikel liefert. Des Weiteren ist es die Aufgabe der vorliegenden Erfindung PEDOT:PSS Partikel bereitzustellen, welche ohne weitere Polymerstabilisierung eine sehr gleichmäßige Form- und Größenverteilung aufweisen.

Die Lösung der Aufgabe erfolgt durch die Merkmale der jeweiligen unabhängigen Ansprüche, gerichtet auf das erfindungsgemäße Verfahren, die erfindungsgemäßen Partikel und die erfindungsgemäße Verwendung der Partikel. Bevorzugte Ausgestaltungen der Erfindung sind in den Unteransprüchen, in der Beschreibung oder den Figuren beschrieben, wobei weitere in den Unteransprüchen oder in der Beschreibung oder den Figuren beschriebene oder gezeigte Merkmale einzeln oder in einer beliebigen Kombination einen Gegenstand der Erfindung darstellen können, wenn sich aus dem Kontext nicht eindeutig das Gegenteil ergibt.

Die Lösung der Aufgabe erfolgt erfindungsgemäß durch ein Verfahren zur Herstellung von Poly(3,4-ethylendioxythiophen):Polystyrolsulfonat (PEDOT:PSS) Partikeln mindestens umfassend die Schritte:
a) Bereitstellen einer Mischung umfassend Poly(3,4-ethylendioxythiophen) und Polystyrol-sulfonat in einem Lösemittel mindestens umfassend Wasser;
b) Ausbilden eines oder mehrerer PEDOT:PSS-Tropfen durch Einbringen der Mischung aus Verfahrensschritt a) in ein organisches Lösemittel A, wobei die wässrige PEDOT:PSS-Mischung das Tropfeninnere und das organische Lösungsmittel A das Tropfenäußere ausbilden;
c) Kontaktieren der PEDOT:PSS-Tropfen erhalten aus Verfahrensschritt b) mit einer Koagulierlösung umfassend ein Aushärtungsmittel und mindestens ein weiteres Lösungsmittel B, wobei die Dichte der Koagulierlösung größer als die Dichte des organischen Lösemittels A und kleiner als die Dichte der wässrigen Poly(3,4-ethylendioxythiophen) und Polystyrolsulfonat-Mischung ist; unter Aushärten der PEDOT:PSS-Tropfen zu PEDOT:PSS-Partikeln.

Überraschenderweise wurde gefunden, dass oben angegebenes Verfahren die flexible Herstellung voller und poröser PEDOT:PSS-Partikel erlaubt, wobei die Partikel auch ohne weitere Verbund- oder Stützsubstanzen mechanisch stabil sind. Durch das Fehlen weiterer mechanisch stabilisierender Substanzen werden die nativen Eigenschaften des Polymersystems in ihrer Gesamtheit erhalten und ungewollte Inkompatibilitäten in der Anwendung vermieden. Das erfindungsgemäße 2-schrittige Verfahren erlaubt eine kostengünstige Produktion und bietet einfache up-scaling Möglichkeiten. Es lassen sich flexibel unterschiedliche Partikelgrößen und - Dichten darstellen, wobei sehr reproduzierbar, bevorzugt runde Geometrien über das Verfahren erhältlich sind. Weiterhin vorteilhaft ist, dass eine sehr homogene und enge Partikelgrößenverteilung erhalten werden kann. Der PEDOT:PSS-Polymerkomplex stellt nach der Reaktion ein biokompatibles, poröses Hydrogel mit sterischen und mechanischen Eigenschaften vergleichbar zu einer extrazellulären Matrix dar und bildet somit eine gute Grundlage für den Einsatz in Zellkulturapplikationen. Der fehlende Zusatz weiterer, stabilisierender Polymere kann sich zudem positiv auf die elektrischen Eigenschaften der Partikel auswirken.

Das erfindungsgemäße Verfahren ist ein Verfahren zur Herstellung von Poly(3,4-ethylen-dio-xythiophen):Polystyrolsulfonat (PEDOT:PSS) Partikeln. Das erfindungsgemäße Verfahren liefert PEDOT:PSS-Partikel, welche aus einer PEDOT-PSS-Matrix bestehen oder diese aufweist. Die Partikel können insofern nur aus diesen beiden Monomeren bestehen oder diese umfassen. Bevorzugt kann die Matrix nur aus PEDOT und PSS bestehen. Die Partikel weisen entweder eine geschlossene, dichte Oberfläche, oder aber eine poröse Struktur auf, wobei im Partikelinneren und/oder auf der Partikeloberfläche dann Poren vorhanden sind. Die Poren können auch einen durchgehenden Diffusionspfad durch einzelne Partikel bereitstellen. Die Partikeldichte kann beispielsweise über den Feststoffgehalt der verwendeten PEDOT-PSS-Lösung eingestellt werden, wobei sich über das Verfahren eine breiter Konzentrationsbereich verarbeiten lässt. Bevorzugt kann der Feststoffgehalt der wässrigen PEDOT:PSS-Lösung größer oder gleich 0,5 Gew.-% und kleiner oder gleich 10 Gew.-%, des Weiteren bevorzugt größer oder gleich 1,0 Gew.-% und kleiner oder gleich 5,0 Gew.-% betragen. Auch mit relativ kleinen Feststoffgehalten lassen sich über das vorgestellte Verfahren hinreichend mechanisch formstabile Partikel erzeugen. Der Porositätsgrad der Partikel kann über den Anteil weiterer Lösemittel in der wässrigen Lösung in weiten Bereichen variiert werden und kann bevorzugt größer oder gleich 0 Volumen-% und kleiner oder gleich 95 Volumen-%, des Weiteren bevorzugt größer oder gleich 15 Volumen-% und kleiner oder gleich 60 Volumen-% betragen.

Im Verfahrensschritt a) erfolgt das Bereitstellen einer Mischung umfassend Poly(3,4-ethylen-dioxythiophen) und Polystyrolsulfonat in einem Lösemittel mindestens umfassend Wasser. Edukt der Herstellung ist eine wässrige PEDOT- und PSS-Mischung, in welcher die Polymerkomplexe aus positiv geladenen PEDOT und negativ geladenen PSS dispergiert vorliegen. Diese wässrige Ausgangslösung kann neben Wasser noch weitere Lösungs- oder auch Dispergiermittel aufweisen, wobei über den Anteil und die Art der Lösemittel beispielsweise die Porosität der Partikel eingestellt werden kann. Der Begriff "Lösemittel" wird hierbei nicht im physikalischen Sinne zur Herstellung einer echten "Lösung" verwendet, sondern in dem Sinne, dass diese Substanzen normalerweise unter die Kategorie eines flüssigen Lösemittels fallen. Wird "nur" Wasser als Löse- oder Dispergiermittel verwendet, so ergeben sich unporöse Partikel. PEDOT:PSS kann beispielsweise in einem molaren Verhältnis von größer oder gleich 1:6 und kleiner oder gleich 6:1 vorliegen. Die Gewichtskonzentration von PEDOT:PSS in der wässrigen Mischung kann beispielsweise größer oder gleich 1 Gew-% und kleiner oder gleich 10 Gew.-% betragen.

Im Verfahrensschritt b) erfolgt die Ausbildung eines oder mehrerer PEDOT:PSS-Tropfen durch Einbringen der Mischung aus Verfahrensschritt a) in ein organisches Lösemittel A, wobei die wässrige PEDOT:PSS-Mischung das Tropfeninnere und das organische Lösungsmittel A das Tropfenäußere ausbilden. Die wässrige PEDOT:PSS-Dispersion wird in einem organischen Lösemittel emulgiert und bildet eine Wasser(PEDOT:PSS)-in-Lösemittel A-Emulsion aus. Das wässrige PEDOT:PSS bildet also die innere und das organische Lösemittel die äußere Phase. Das organische Lösungsmittel A darf also nicht vollständig mit Wasser mischbar sein. Bevorzugt kann das organische Lösemittel A eine Mischbarkeit von Wasser von kleiner oder gleich 10 g/l, des Weiteren bevorzugt von kleiner oder gleich 5g/l bei 20°C aufweisen. Das Emulgieren kann ohne den weiteren Einsatz von Emulgatoren, rein auf mechanischem Wege erfolgen. So kann sich der Einsatz eines mechanischen Rührers, eines Turrax oder eines mikrofluidischen Aufbaus mit T-Abzweigungsgeometrie zum Erhalt einer Emulsion mit einer möglichst einheitlichen Tröpfchengröße anbieten. Die Emulsion lässt sich aber auch über eine Ultraschallbehandlung erhalten. Die Emulsion muss nicht über längere Zeiten stabil sein. Als organische Lösemittel A bieten sich organische Lösemittel an, welche gegenüber den chemischen Bedingungen im weiteren Verfahrensverlauf stabil sind. Beispielsweise können dies mittelkettige Kohlenwasserstoffe ohne weitere reaktive Gruppen sein. So können beispielsweise C4-C10 Kohlenwasserstoffe oder Alkane eingesetzt werden. Des Weiteren ist es aber auch möglich, organische Lösungsmittel einzusetzen, welche aus Kohlenwasserstoffen und einer oder mehreren weiteren funktionalen Gruppen bestehen. So können beispielsweise auch mittelkettige Alkohole, beispielsweise C5-C10-Alkohole als Lösungsmittel A eingesetzt werden.

Der Verfahrensschritt b) kann beispielsweise innerhalb eines co-axialen Tropfenabrissverfahrens, in dem die Emulsionstropfen durch eine kontinuierliche Phase von der Düse abgetrennt, erfolgen. Das PEDOT:PSS wird dadurch in eine sphärische Form überführt. Die kontinuierliche Phase aus dem Lösungsmittel A hüllt hierbei die PEDOT:PSS-Emulsion vollständig ein und dient als Hülle zur Verzögerung des Aushärtungsprozesses. Die Erzeugung monodisperser PEDOT:PSS-Emulsionstropfen in der kontinuierlichen Phase kann beispielsweise mittels einer oder mehrerer Kanüle erfolgen, welche konzentrisch in einen leicht abgeknickten Schlauch eingeführt sind. Dabei wird durch den Schlauch die kontinuierliche Phase aus dem Lösemittel A und über die Kanüle die PEDOT:PSS-Emulsion zugeführt. Die Schutzhülle bestehend aus der kontinuierlichen Phase des Lösemittels A und verhindert das Aushärten der PEDOT:PSS-Emulsion innerhalb der Düse und das Verblocken der Apparatur. Der Prozess kann ohne die verzögernde Wirkung des Tropfenäußeren, bestehend aus dem Lösemittel A, als kontinuierliche Phase nicht durchgeführt werden. Zur Ausbildung weiterer Formkörper-Geometrien können auch Schlitz- oder Düsen anderer Ausgestaltung eingesetzt werden. Durch die Wahl der Extrusionsmenge und -Geschwindigkeit können auch mehr oder weniger längliche Formkörper, wie beispielsweise Fasern, hergestellt werden.

Im Verfahrensschritt c) werden die PEDOT:PSS-Tropfen erhalten aus Verfahrensschritt b) mit einer Koagulierlösung umfassend ein Aushärtungsmittel und mindestens ein weiteres Lösungsmittel B kontaktiert. Durch den mechanischen Energieeintrag wurde, zumindest temporär, aus dem organischen Lösemittel A und der wässrigen PEDOT:PSS-Lösung eine Emulsion mit PEDOT:PSS-Tropfen erhalten, wobei die Tropfen durch eine äußere Lösemittel A Phase geschützt vorliegen. Diese eingehüllten Tropfen werden nun in eine Koagulierlösung überführt. Das Überführen der eingehüllten Tropfen in die Koagulierlösung kann direkt aus dem Schlauch, welcher beispielsweise für das Zuführen der kontinuierlichen Phase in Verfahrensschritt b) verwendet wurde, erfolgen. Die Schutzhülle bestehend aus der kontinuierlichen Phase wird dann zügig über die Dichtedifferenz zwischen dem Koagulationsbad und der kontinuierlichen Phase vom PEDOT:PSS Emulsionstropfen abgetrennt, wodurch die Emulsion aus wässriger PEDOT:PSS-Lösung auf die Koagulierlösung trifft, welche mindestens ein weiteres Lösemittel B und ein Aushärtungsmittel umfasst. Bevorzugt kann das Aushärtungsmittel im organischen Lösemittel B homogen gelöst oder dispergiert vorliegen. Als Aushärtungsmittel können dabei jedwede Substanzen eingesetzt werden, welche in der Lage sind PSS aus dem PEDOT-PSS-Polymerkomplex herauszulösen und eine Kristallisation der PEDOT zu bewirken. Bevorzugt kann das Aushärtungsmittel im organischen Lösemittel B gelöst vorliegen. Mögliche Aushärtungsmittel können beispielsweise aus der Gruppe bestehend aus Schwefelsäure, ionischen Flüssigkeiten, hochkonzentrierten Salzlösungen oder Mischungen mindestens zweier Aushärtungsmittel aus dieser Liste ausgesucht sein. Geeignete organische Lösemittel B können beispielsweise aus der Gruppe bestehend aus verzweigten oder unverzweigten C1-C10 Alkoholen oder Wasser oder Mischungen mindestens zweier Lösemittel daraus ausgesucht sein. Geeignete organische Lösemittel müssen eine Dichte kleiner als PEDOT:PSS aufweisen, um die Abtrennung der schützenden Lösemittel A Hülle zu ermöglichen und sollten bestenfalls eine hohe Löslichkeit hinsichtlich des Lösemittels A aufweisen.

Die Dichte der Koagulierlösung ist größer als die Dichte des organischen Lösemittels A und kleiner als die Dichte der wässrigen PEDOT:PSS-Mischung. Die Dichte der Koagulierlösung aus organischem Lösemittel B und Aushärtungsmittel muss also erfindungsgemäß größer sein als die Dichte des organischen Lösemittels A, sowie größer als die Dichte weiterer Lösemittel in den Fällen, in denen die wässrige PEDOT:PSS-Mischung noch weitere Lösemittel aufweist. Diese Relation der unterschiedlichen Lösemittel kann beispielsweise über die Dichte der Koagulierlösung gesteuert werden. Die Dichte der Koagulierlösung kann prinzipiell über zwei unterschiedliche Parameter beeinflusst werden. Zum einen kann sich natürlich die Dichte der Koagulierlösung über die Wahl des Lösemittels B selbst ergeben. Zum anderen kann durch die Wahl der Konzentration des Aushärtungsmittels in dem Lösemittel B die Dichte des Lösemittels B selbst weiter angepasst werden. Die Dichten aus organischem Lösemittel A und organischem Lösemittel B inklusive Aushärtungsmittel werden zum Erhalt der oben angegebenen Relation natürlich unter gleichen Temperaturbedingungen miteinander verglichen. Weist die Koagulierlösung neben dem Aushärtungsmittel und dem Lösemittel B noch weitere, dichterelevante Beimischungen oder Substanzen auf, so zählen diese mit zur Dichte der Koagulierlösung. Die Änderungen der Dichte der Koagulierlösung durch das Eintropfen der Emulsion bleibt unberücksichtigt, da das Volumen der Koagulierlösung gegenüber dem Volumen der eingetropften Lösung als sehr groß angesehen wird. Die Dichte der Koagulierlösung aus Lösemittel B und Aushärtungsmittel muss zudem gegenüber der wässrigen PEDOT:PSS-Mischung kleiner sein. Bevorzugt können die Dichteunterschiede zwischen wässriger PEDOT:PSS-Mischung, organischem Lösemittel A und Koagulationsbad umfassend organisches Lösemittel B + Aushärtungsmittel größer oder gleich 5%, des Weiteren bevorzugt größer oder gleich 10% betragen. Innerhalb dieser Dichteunterschiede lassen sich die aus organischem Lösemittel A bestehende Schutzschicht der PEDOT:PSS-Tropfen sehr schnell entfernen und es können sehr gleichmäßige Partikel hergestellt werden. Es zählt der absolute Dichteunterschied, wobei als Funktion des Vorzeichens des Dichteunterschiedes die Lösung einmal von oben oder von unten in das Koagulationsbad eingeführt werden kann. Die Abtrennung der schützenden Hülle bestehend aus Lösungsmittel A wird weiterhin durch die Löslichkeit von Lösungsmittel A in Lösungsmittel B unterstützt.

Durch das Einleiten der in das Lösemittel A eingehüllten PEDOT:PSS-Emulsion in die Koagulierlösung werden die PEDOT:PSS-Tropfen zu PEDOT:PSS-Partikeln ausgehärtet. Die oben angegebenen Dichterelationen erlauben es, dass die Hülle um die PEDOT:PSS-Tropfen herum aufgrund der Dichtedifferenz sowie der Löslichkeit in Lösungsmittel B von der wässrigen PEDOT:PSS-Mischung langsam abgetrennt wird. Der Schutz der innenliegenden wässrigen PEDOT:PSS-Tropfen durch das organische Lösemittel A wird entfernt und das Aushärten des PEDOT:PSS-Komplexes im Koagulationsbad durch das Aushärtungsmittel beginnt. Das Aushärtemittel führt zu einer Teilkristallisation des PEDOT:PSS-Tropfens, wobei das Lösemittel B gleichtzeitig zu einer Nichtlösungsmittel-induzierten Phasenseparation führt. Somit härtet der PEDOT:PSS-Tropfen durch die Interaktion mit dem Koagulationsbad innerhalb kurzer Zeit vollständig zum Partikel aus. Im Falle poröser Partikel können sich noch zusätzlich 1 bis 40 µm große Emulsionstropfen bestehend einem Lösungsmittel, beispielsweise aus Lösungsmittel A, innerhalb des PEDOT:PSS Partikels, die während des Aushärteverfahrens im Koagulationsbad die Porosität des Partikels bilden. Diese verbleibenden Tropfen des organischen Lösemittels A, die noch immer in den Partikeln präsent sind, können neben der Erzeugung einer Partikelporosität weiterhin als Gerüst für die Ausbildung einer sphärischen Form dienen. Liegen in der wässrigen PEDOT:PSS-Mischung noch weitere, durch Dichteunterschiede herauslösbare Lösemittel vor, so sorgen diese für die Ausbildung einer ausgehärteten Porosität. Da das organische Lösemittel B teilweise auch ein Lösungsmittel für das organische Lösemittel A darstellen kann, garantiert der Aufbau nicht nur die ausreichende Partikelverfestigung, sondern auch die Befreiung der Partikelporen vom weiteren Lösemittel.

In einer bevorzugten Ausgestaltung des Verfahrens kann das organische Lösemittel A aus der Gruppe bestehend aus verzweigten oder unverzweigten C5-C10 Alkanen, verzweigten oder unverzweigten C5-C10 Alkoholen oder Mischungen mindestens zweier Lösemittel daraus ausgesucht sein. Zum Erhalt einer hinreichend stabilen Emulsion der wässrigen PEDOT:PSS-Mischung im organischen Lösemittel A, hat sich oben angegebene Lösemittelgruppe als besonders geeignet herausgestellt. Es lassen sich mit sehr geringen Scherkräften ausreichend homogene und kleine Tropfen erzeugen, welche eine nicht zu hohe Löslichkeit für Wasser aufweisen. Ohne durch die Theorie gebunden zu sein kann es zudem vorteilhafterweise dazu kommen, dass die Oberflächenporosität der Partikel durch diese Lösemittelauswahl besonders positiv beeinflusst wird. Ein weiterer Vorteil kann zudem darin bestehen, dass für den Fall, dass die wässrige PEDOT:PSS-Mischung weitere Lösemittel zur Ausbildung einer Porosität aufweist, die Befreiung der Poren vom Lösungsmittel aufgrund einer möglichen guten Lösbarkeit im Lösungsmittel B besonders schnell verläuft.

Innerhalb eines bevorzugten Aspektes des Verfahrens kann des Weiteren Lösemittel B aus der Gruppe bestehend aus verzweigten oder unverzweigten C1-C5 Alkoholen oder Mischungen mindestens zweier Substanzen daraus ausgesucht sein. Diese Gruppe an Lösemitteln B im Koagulationsbad hat sich für eine Reihe unterschiedlicher Aushärtemittel als hinreichend stabil herausgestellt. Des Weiteren weisen diese Lösemittel eine ausreichend hohe Löslichkeit für die wichtigsten Aushärtemittel auf, sodass sich ein homogenes Koagulationsbad ergibt. Ein weiterer Vorteil dieser Gruppe besteht darin, dass sich eine bevorzugte Interaktion mit eventuell im Tropfen emulgierten Lösemittel A ergibt. Das Herauslösen des Lösungsmittels A erfolgt innerhalb eines optimalen Zeitfensters, sodass ausreichend Zeit zur Verfügung steht, um die Tropfenform während der Aushärtung zu stabilisieren sowie innerhalb desselben Prozessschrittes die umgebende organische Phase vollständig vom Partikelinneren zu trennen.

In einer weiter bevorzugten Ausführungsform des Verfahrens kann das Lösemittel A Oktanol und die Koagulierlösung im Verfahrensschritt b) Isopropanol als Lösemittel B und Schwefelsäure als Aushärtungsmittel umfassen. Diese Kombination aus Löse- und Aushärtungsmitteln in den unterschiedlichen Verfahrensschritten hat sich als besonders vorteilhaft herausgestellt. Es ergeben sich besonders stabile und homogen vernetzte PEDOT:PSS-Partikel, welche sich zudem noch durch eine besonders gleichmäßige Porosität auszeichnen können. Ohne durch die Theorie gebunden zu sein, ergeben sich die synergistischen Vorteile aus einer besonders vorteilhaften Löslichkeit der Lösemittel A und B in- und miteinander. Der von der Oktanolhülle befreite Tropfen kommt in Kontakt mit dem Koagulationsgemisch und härtet durch Interaktion mit der Schwefelsäure als Aushärtungsmittel vollständig aus. Die Oktanoltropfen, die in der wässrigen PEDOT:PSS-Lösung oder -Dispersion noch immer in emulgierter Form vorliegen, können dabei insbesondere als Gerüst für die Ausbildung einer sphärischen Form wirken und sorgen für die Ausbildung einer gesteuerten Porosität. Da Isopropanol ein partielles Lösungsmittel für Oktanol und ggf. das weitere emulgierte Lösungsmittel darstellt, garantiert das Koagulationsgemisch nicht nur für die Partikelaushärtung durch Entfernung der Tropfenhülle, sondern auch für eine gesteuerte Befreiung der Poren vom weiteren Lösemittel. Bevorzugt kann als Oktanol 1-Oktanol eingesetzt werden. Letzteres kann zur Ausbildung besonders gleichförmiger Tropfen beitragen.

Im Rahmen eines bevorzugten Aspektes des Verfahrens kann das Gewichtsverhältnis von Aushärtungsmittel und Lösemittel B in der Koagulierlösung, ausgedrückt als Gewicht Aushärtungsmittel dividiert durch Gewicht Lösemittel B, größer oder gleich 0,005 und kleiner oder gleich 0,2 betragen. Für eine effiziente und gesteuerte Aushärtung unter Erhalt besonders gleichmäßiger, sphärischer PEDOT:PSS-Partikel hat sich oben angegebenes Verhältnis als besonders geeignet herausgestellt. Zum einen wird die Ablösegeschwindigkeit des umhüllenden Lösemittels A, gegebenenfalls die Entfernung weiteren Lösemittels aus der wässrigen PEDOT:PSS-Mischung, und die anschließende Kontaktzeit mit dem Aushärtungsmittel einem dynamischen Gleichgewicht unterworfen, welches auf Basis kinetischer Überlegungen insbesondere zur Ausbildung eher sphärischer Partikel genutzt werden kann. So können höhere Mengen an Aushärtungsmittel zur Ausbildung eher unrunder Partikel beitragen. Niedrigere Gehalte an Aushärtungsmittel können eher dazu beitragen, dass nur eine ungenügende Verfestigung der PEDOT:PSS Tropfen erreicht wird oder zu lange Kontaktzeiten im Koagulationsbad benötigt werden. In einer bevorzugten Ausführungsform kann die untere Grenze des Bereiches 0,01 betragen.

In einer weiter bevorzugten Charakteristik des Verfahrens kann die PEDOT:PSS-Mischung im Verfahrensschritt a) keine weiteren mechanisch verfestigenden Substanzen aufweisen. Überraschenderweise hat sich herausgestellt, dass über das erfindungsgemäße Verfahren mechanisch sehr stabile Partikel erhältlich sind, welche neben PEDOT und PSS von weiteren mechanischen verfestigenden Substanzen im Sinne mechanischer Stabilisatoren frei sind. Üblich verfestigende Substanzen sind ausgewählt aus der Gruppe polymerer Beimischungen oder rein stützender oder formgebender Feststoffe. Diese Substanzen sind auch unter dem Begriff der "template particles" dem Fachmann bekannt. Im Bereich der polymeren Beimischungen bedeutet dies, dass die eingesetzte PEDOT:PSS-Lösung beispielsweise frei von weiteren Monomeren oder Polymeren sein kann. Polymere Bestandteile können beispielsweise Substanzen sein, welche ein Molekulargewicht von größer oder gleich 2.000 g/mol aufweisen, wobei diese Substanzen sich in der wässrigen PEDOT:PSS-Lösung befinden können oder sich im Laufe der Herstellung bilden. Weiterhin können die PEDOT:PSS Partikel frei von weiteren mechanisch verfestigenden Substanzen wie beispielsweise Kunststoffmikropartikeln z.B. Polystyrolmikropartikeln, Siliciumdioxid-Mikropartikeln oder Salzkristallen wie Calciumcarbonat sein. Die Gruppe der verfestigenden Substanzen mit nicht-polymeren Charakter umfasst insofern mindestens Salzkristalle, Kunststoffmikropartikel, Quarz-Mikropartikel oder Mischungen daraus. Daneben kann die eingesetzte PEDOT:PSS-Lösung dennoch weitere niedermolekulare Substanzen aufweisen, welche beispielsweise die elektrischen Eigenschaften des PEDOT:PSS-Netzwerk beeinflussen oder anpassen können.

Innerhalb eines weiter bevorzugten Aspektes des Verfahrens kann die wässrige PEDOT:PSS-Mischung im Verfahrensschritt a) neben Wasser als weitere Lösemittelkomponente ein organisches Lösemittel A aufweisen. Zur Ausbildung einer gesteuerten Porosität und zur Ausbildung mechanisch stabiler Partikel hat sich die Verwendung eines Lösemittels A zur Erzeugung einer Emulsion von Lösemittel A in wässriger PEDOT:PSS Lösung als einfach und effizient herausgestellt. Die Anzahl an beteiligten Substanzen wird gering gehalten und die Abtrennung aus der Emulsion erfolgt schnell und weitgehend vollständig. Des Weiteren kann der Volumenanteil des Lösemittels A am Gesamtvolumen der wässrigen PEDOT:PSS-Mischung größer oder gleich 15 % und kleiner oder gleich 60% betragen. Innerhalb dieser Volumenanteile des organischen Lösemittels A in der wässrigen Mischung lassen sich innerhalb sehr kurzer Prozesszeiten mechanisch sehr stabile Partikel erhalten, welche zudem eine sehr gleichmäßige Porengrößenverteilung aufweisen. Kleinere Anteile können nachteilig sein, da aufgrund der nur vereinzelt vorliegenden Lösungsmittel A Tropfen keine vernetzte Porosität, sondern nur vereinzelte Defekte im Partikel entstehen können. Höhere Anteile können zu einer nur ungenügenden mechanischen Stabilität der Partikel beitragen.

Des Weiteren erfindungsgemäß sind Poly(3,4-ethylendioxythiophen)-Polystyrolsulfonat-Partikel, wobei die Partikel sphärisch ausgebildet sind und neben PEDOT:PSS keine weiteren mechanisch verfestigenden Substanzen aufweisen. Selbst ohne weitere mechanisch verfestigende Beimischungen im Edukt oder im ausgebildeten Partikel lassen sich mechanisch äußerst stabile PEDOT:PSS-Partikel erhalten, welche sich zudem durch eine besonders gleichmäßige, sphärische Gestalt auszeichnen. Die verfestigenden Substanzen sind dabei weiter oben im Zusammenhang mit dem erfindungsgemäßen Verfahren definiert. Polymere Bestandteile können beispielsweise Substanzen sein, welche ein Molekulargewicht von größer oder gleich 2.000 g/mol aufweisen, wobei diese Substanzen sich in der wässrigen PEDOT:PSS-Lösung befinden können oder sich im Laufe der Herstellung bilden. Neben der besonderen Ausgestaltung in Form von Kugeln, können die Partikel zudem eine besonders enge Kugelgrößenverteilung aufweisen.

Die sphärische Ausgestaltung kann beispielsweise mathematisch durch die Sphärizität der Partikel erfasst werden, welche erfindungsgemäß größer oder gleich 0,91 sein kann. Dieser Sphärizitäts-Bereich kann mikroskopisch bestimmt werden und beschreibt allgemein das Verhältnis der Oberfläche einer Kugel gleichen Volumens zur Oberfläche des vorliegenden Körpers. Zur Bestimmung kann ein Mittelwert mindestens 20 einzelner Partikel herangezogen werden. Des Weiteren kann die Sphärizität der Partikel größer oder gleich 0,95 und kleiner oder gleich 1 betragen. Des Weiteren können die Partikel frei von Emulgatoren, Netzmitteln oder weiteren oberflächenaktiven Substanzen sein, welche üblicherweise zur Herstellung von Emulsionen verwendet werden.

Des Weiteren erfindungsgemäß sind PEDOT:PSS Partikel hergestellt nach dem erfindungsgemäßen Verfahren. Neben der Größenverteilung, der mechanischen Stabilität und der Porosität können über das erfindungsgemäße Verfahren noch weitere Eigenschaften festgelegt werden, welche sich von den Eigenschaften nach dem Stand der Technik hergestellter Verfahren unterscheiden. Für die weiteren Vorteile dieser über das erfindungsgemäße Verfahren erhältlichen Partikel wird explizit auf die in Verbindung mit dem erfindungsgemäßen Verfahren genannten Vorteile verwiesen.

Innerhalb eines weiter bevorzugten Aspektes der Partikel können die Partikel ein Elastizitätsmodul von größer oder gleich 0,05 MPa und kleiner oder gleich 15 MPa aufweisen. Die mechanischen Eigenschaften der erfindungsgemäßen Partikel können auch ohne den Zusatz weiterer mechanisch wirksamer Substanzen über einen weiten Bereich eingestellt werden. Neben der Porosität der Partikel kann dabei insbesondere die Kristallinität einen großen Einfluss auf das Elastizitätsmodul aufweisen. Der Kristallisationsgrad der einzelnen Kettensegmente kann beispielsweise über die Säure-Katalysatorkonzentration beeinflusst werden, wobei die Säurekonzentration die molekularen Anordnung der einzelnen Kettensegmente untereinander beeinflusst. Das Elastizitätsmodul (Young-Modulus) der Partikel kann über Zugversuche an streifenförmigen Partikeln ermittelt werden. Die Bestimmung des Elastizitätsmodul erfolgt dabei an Partikeln in Faserform im nassen Zustand wie beispielsweise in den Beispielen beschrieben.

Nach einer bevorzugten Charakteristik der Partikel kann der Partikel zumindest teilkristallin mit Bragg-Reflexen in einem XRD-Spektrum bei 4,3 (+- 0,2) nm⁻¹ und 18,4 (+-0,2) nm⁻¹ sein. Über das erfindungsgemäße Verfahren lassen sich mechanisch sehr stabile Partikel erhalten, welche sich insbesondere auch durch einen hohen Kristallisationsgrad auszeichnen. Der Kristallisationsgrad kann dabei insbesondere zu Partikeln mit einem hohen elastischen Modul führen. Die kristallinen Partikel zeichnen sich durch ein Festkörper-Pulverröntgendiffraktogramm aus, welches sichtbare Reflexe bei oben angegebenen Positionen zeigt. Des Weiteren kann das Diffraktogramm noch einen weiteren Peak bei 8,6 nm⁻¹ zeigen. Das Verhältnis der Peakhöhen bei 4,3 und 8,6 nm⁻¹ kann beispielsweise 1:2 betragen. Diese Reflexe können der lamellaren Anordnung der einzelnen Ketten mit einer Periodizität von 1,5 nm im Partikel zugeordnet werden. Der Reflex bei ca. 18 nm⁻¹ ergibt sich hochwahrscheinlich durch regelmäßig angeordnete π- π-Stapel benachbarter PEDOT-Ketten. Im Gegensatz dazu zeigen weniger kristalline Partikel, beispielsweise hergestellt mit geringen Säurekonzentrationen im Koagulationsbad, eine mit nur 1,8 nm geringe Größe der kristallinen Regionen. In diesen Partikeln mit geringer Kristallinität lassen sich keine ausgeprägten lamellaren Struktur über definierte Bragg-Reflexe nachweisen.

In einer weiter bevorzugten Ausführungsform der Partikel kann die Oberfläche des Partikel ein Zetapotential von kleiner oder gleich 0 mV aufweisen. Über das erfindungsgemäße Verfahren lassen sich ohne Zusatz weiterer polymerer Gerüstsubstanzen oder mechanisch wirksamer Füllstoffe besonders geeignete, mechanisch stabile Partikel erhalten, welche sich zudem noch durch eine günstiges, negatives Zeta-Potential auszeichnen. Diese negative Oberflächenladung kann insbesondere im Bereich der Zellkulturen zu einer verbesserten Funktionalisierung der Partikeloberflächen beitragen. Die elektrisch negative Funktionalisierung der Oberfläche kann mehrschrittig genutzt werden, um beispielsweise eine positive Ladung aufzubringen und so anschließend eine verbesserte Zellanhaftung zu erhalten. Es können sich also biokompatiblere Partikel ergeben, welche eine schnellere Anhaftung und eine verbesserte Proliferation der Zellen auf und im Partikel zeigen. Das Zetapotential kann beispielsweise über eine kombinierte optische/elektrische Messung bestimmt werden, welche die Wanderungsgeschwindigkeit der Partikel als Funktion einer angelegten Spannung misst. Der Einfluss der einzelnen Partikelgeometrien auf das Messergebnis ist dem Fachmann bekannt und diese Effekte können herausgerechnet werden. Bevorzugt kann die Oberflächenladung kleiner oder gleich - 10 mV, des Weiteren bevorzugt kleiner oder gleich -15 mV betragen. Die untere Grenze des Potentials kann beispielsweise bei - 75 mV, des Weiteren bevorzugt bei - 50 mV liegen.

In einer bevorzugten Ausgestaltung der Partikel können die Partikel eine Größenverteilung mit einem D50-Quantil in einem Bereich von größer oder gleich 10 µm und kleiner oder gleich 1.000 µm aufweisen. Die über das erfindungsgemäße Verfahren erhältlichen Partikel können über einen weiten Größenbereich über die Wahl der Düsengröße sowie des Flussratenverhältnisses zwischen kontinuierlicher Phase und wässriger PEDOT:PSS Dispersion hergestellt werden. Es ergeben sich sehr homogene Größenverteilungen, welche einen Polydispersitätsindex von kleiner oder gleich 1,2, des Weiteren bevorzugt von kleiner oder gleich 1,1 aufweisen können. Der Polydispersitätsindex kann dabei über mikroskopische Messungen bestimmt werden.

Im Rahmen einer bevorzugten Ausgestaltung der Partikel können diese porös sein und eine Porosität von größer 0 Volumen-% und kleiner oder gleich 95 Volumen-% aufweisen. Es hat sich gezeigt, dass mittels des erfindungsgemäßen Verfahrens eine große Bandbreite an Partikel-Porositäten zugänglich ist, wobei es insbesondere erstaunlich ist, dass auch unter hohen Porositäten die Partikel eine hinreichende mechanische Festigkeit, selbst in Abwesenheit weiter stabilisierenden Substanzen, zeigen. Es können somit Partikel bereitgestellt werden, welche sehr hohe spezifische Oberflächen zeigen und welche keine beispielsweise elektrisch störende oder inaktive Substanzen aufweisen. Der Partikelporosität kann beispielsweise über Mikroskopie an gefriergetrockneten Partikeln bestimmt werden.

Des Weiteren erfindungsgemäß kann die Verwendung der erfindungsgemäßen Partikel aus der Gruppe bestehend aus Zellkultur-Mikroträgern, Suspensionselektroden, schaltbares Redox-Absorbermaterial, Katalysatorträger oder Kombinationen daraus ausgesucht sein. Aufgrund der Gleichmäßigkeit in der Größenverteilung, der steuerbaren Porosität und der Tatsache, dass neben PEDOT:PSS keine weiteren mechanisch verfestigenden und/oder oberflächenaktive Substanzen auf oder in den Partikeln vorhanden sein müssen, eignen sich die Partikel für eine Reihe unterschiedlicher Anwendungen. Im Falle des Einsatzes als Suspensionselektrode ergibt sich durch die Verwendung der Partikel ein mehrphasiges Materialsystem, welches als aktive ladungsspeichernde Komponente die Partikel aufweist. Diese können in einer ionischen Lösung oder einem Elektrolyten suspendiert vorliegen. Gravimetrisch gesehen ist der Elektrolyt die Hauptkomponente und trägt zum physikalischen Transport des aktiven Materials bei. Die Innere- und die Oberflächenporosität der erfindungsgemäßen Partikel führt zu einer Verbesserung der elektrochemischen Eigenschaften, unter anderem zu einer verbesserten Nutzung der elektrischen Kapazität sowie einer schnelleren Lade- und Entladekinetik, wodurch die erfindungsgemäßen Partikel ein hohes Potential hinsichtlich elektrochemischer Energiespeicher in Form von Superkondensatoren oder Batterien zeigen. Die über das erfindungsgemäße Verfahren flexibel herstellbaren PEDOT:PSS-Partikel sind nicht-toxisch und somit zellkompatibel und weisen neben einer hohen mechanischen Stabilität in wässrigen Systemen auch noch eine ausgezeichnete Redox-Reversibilität auf. Die erreichbaren Leitfähigkeiten sind, im Vergleich zu den Standder-Technik-Polymerpartikeln, höher. Des Weiteren weisen die erfindungsgemäßen PEDOT:PSS-Partikel als Materialsystem eine sehr schnelle Ladungs-Endladungskinetik auf, wobei die Ladung nicht nur in einer oberflächlichen, elektrischen Doppelschicht sondern auch innerhalb der Polymermatrix gespeichert werden kann. Letzteres resultiert insbesondere in einer hohen Energie- und Leistungsdichte der Partikel.

Innerhalb eines bevorzugten Aspektes der Verwendung können die Partikel als Zellkultur-Mikroträger verwendet werden, wobei die Oberfläche der Partikel vor der Kultivierung mit einer oder mehreren Molekülen ausgewählt aus der Gruppe unter anderem bestehend aus Poly-L-Lysin, Laminin, Collagen, Fibronectin, Vitronectin oder Mischungen daraus beschichtet werden. Durch den Ausschluss weiterer Trägersubstanzen in der Partikel-Grundstruktur können sich im hohen Maße biokompatible Träger ergeben, welche aufgrund ihrer Oberflächenladung zudem die Möglichkeit zur nachträglichen elektrostatischen Funktionalisierung bieten. Es können sämtliche extrazellulären Matrixproteine auf die Partikel beschichtet werden, welche in wässrigen Lösungen einen isoelektrischen Punkt < 7 aufweisen. Diese Verbindungen weisen somit eine negative Ladung auf und können somit beispielsweise auf Poly-L-Lysin haften. Auf der Oberfläche können beispielsweise weitere geladene Bestandteile der extrazellulären Matrix oder aber synthetische Polyelektrolyte gebunden werden. Diese Bestandteile können eine schnellere und bessere Anhaftung, sowie eine höhere Zellteilungsrate bewirken.

In einer weiteren Ausgestaltung der Verwendung kann die Oberfläche der Partikel zuerst mit Poly-L-Lysin und anschließend mit Laminin beschichtet werden. Eine sukzessive und doppelte Beschichtung kann zu einer verbesserten Biokompatibilität der Träger beitragen. Es können auch schwierig zu kultivierende Zelllinien unter hohen Ausbeuten prozessiert werden. Zur Beschichtung kann die Oberfläche der Partikel zuerst mit Poly-L-Lysin behandelt werden. Nach ausreichender Absorption des Poly-L-Lysins kann dann in einem zweiten Schritt Laminin auf die aufgebrachte Poly-L-Lysin-Schicht absorbiert werden.

### Beispiele

### I Aufbau

Das mikrofluidische Co-Flow Gerät zur Produktion erfindungsgemäßer sphärischer PEDOT:PSS-Partikel wird aus einem Polyethylenschlauch mit einem inneren Durchmesser von 0,86 mm, einer 30G Einwegkanüle sowie Epoxy-Kleber hergestellt. Der Schlauch wird im 45° Winkel abgebogen und auf einem Mikroskopieglasträger mit dem Epoxy-Kleber fixiert. Die Kanüle wird daraufhin an der Biegung in den Schlauch eingeführt. Die Kanüle wird schließlich konzentrisch im Schlauch positioniert und mit Epoxy-Kleber am Mikroskopieglasträger befestigt. Hierbei stellt das Ende des Polyethylenschlauches, welches in Richtung der Kanülenspitze zeigt den späteren Apparateausgang dar, während das der Kanülenspitze abgewandte Ende der Eingang für die kontinuierliche Phase ist. Der männliche Schraubverschluss der eingeführten 30G Einwegkanüle wird anschließend an einem weiblich-weiblich Verbinder angeschlossen, welcher über eine zweite 30G Einwegkanüle mit einem weiteren Polyethylenschlauch verbunden wird. Dieser Polyethylenschlauch wird im Herstellungsprozess für die Zuführung der reinen PEDOT:PSS-Dispersion (volle Partikel) bzw. der 1-Oktanol-PEDOT:PSS-Emulsion (Poröse PEDOT:PSS Partikel) verwendet.

### II Partikelherstellung

Zur Herstellung der vollen PEDOT:PSS Partikel wird eine 10 mL Einwegspritze mit einer 1,3 Gew.% wässrigen PEDOT:PSS Mischung (Haereus) gefüllt. Die aufgezogene Spritze wird anschließend über eine 30G Kanüle mit dem entsprechenden Schlauchende der Co-Flow Apparatur verbunden. Mit Hilfe einer weiteren 10 mL Einwegspritze wird als Lösemittel A 1-Oktanol aufgezogen. Diese Spritze wird über eine 30G Kanüle mit dem Schlauchende verbunden. Die beiden aufgezogenen Spritzen werden schließlich in den Halterungen zweier separater Spritzenpumpen befestigt, welche zur Förderung der jeweiligen Phase eingesetzt werden. Optimaler Weise kann die Förderrate der wässrigen PEDOT:PSS Basislösung auf 0,01 mL/min und die Förderrate des 1-Oktanol auf 0,5 mL/min eingestellt werden. Diese Werte haben sich für die Tropfenbildung als besonders günstig herausgestellt, da sie einen genügend großen Tropfenabstand im Schlauch garantieren und zur gewünschten Tropfengröße führen. Zur Aushärtung werden die noch flüssigen PEDOT:PSS Tropfen zusammen mit der umgebenden kontinuierlichen 1-Oktanol Phase über das Schlauchende in ein Koagulationsbad bestehend aus 5 vol.% Schwefelsäure und 95 vol.% Isopropanol geleitet. Die den PEDOT:PSS Tropfen umhüllende 1-Oktanol-Hülle verhindert dabei, dass das PEDOT:PSS in der Kanüle aushärtet und wird später im Koagulationsbad über den Dichteunterschied schonend entfernt. Mit der Entfernung der 1-Oktanol-Hülle durch Ablösen im Koagulationsbad beginnt der Aushärtungsprozess des PEDOT:PSS Tropfens, welcher aufgrund der höheren Dichte im Koagulationsbad sedimentiert. Während des Aushärtungsprozesses wird PSS aufgrund einer Komplexbildung mit H⁺-Ionen aus dem Polyelektrolytkomplex PEDOT:PSS entfernt, wodurch das hydrophobe PEDOT aggregiert und über π-π Wechselwirkungen kristallisiert. Am Gefäßboden des Koagulationsbades können letztendlich vollständig ausgehärtete, reine PEDOT:PSS Partikel abgegriffen werden.

Zur Produktion poröser PEDOT:PSS Partikel bleibt der Versuchsaufbau unverändert. Allerdings wird anstelle einer reinen wässrigen 1,3 Gew.% PEDOT:PSS Lösung eine 1-Oktanol (Lösungsmittel A) in PEDOT:PSS Emulsion in eine Spritze gefüllt. Die Emulsion wird dabei mit einem UP200S von Hielscher Ultrasound Technology mit 0,5 Zyklen und einer Amplitude von 50%, 1 min lang emulgiert. Je nach gewünschter Porosität kann das Volumenverhältnis von 1,3 Gew.% PEDOT:PSS Lösung und dem weiteren Lösemittel aus der Gruppe A, beispielsweise 1-Oktanol, in der Emulsion variiert werden. Für Zellkulturversuche können sich Partikel mit einem 30 vol.% Anteil an 1-Oktanol in der 1,3 Gew.% wässrigen PEDOT:PSS Lösung eignen.

### III Messmethodik

### III.1 XRD-Messungen

Die Pulver-Röntgendiffraktionsspektroskopie (WAXS) wurde mit einem Empyrean-Setup von PANalytical durchgeführt. Eine Cu-Röntgenröhre (Linienquelle von 12 × 0,04 mm 2 ) lieferte CuK α-Strahlung mit λ = 0,1542 nm. Quelle und Detektor bewegten sich in vertikaler Richtung um eine fixierte horizontale Probe. Nach Passieren eines Divergenzspaltes von 1/8° und eines Antistreuspaltes von 1/4° erreichte der Strahl die Probe in der Mitte eines phi-chi-z-Tisches. In der verwendeten Bragg-Bretano-Geometrie wurde der Strahl an einem sekundären Divergenzspalt von 1/4° refokussiert. Schließlich wurde das Signal mit einem Pixeldetektor (256 × 256 Pixel von 55 µm) als Funktion des Streuwinkels 2θ aufgezeichnet. Anschließend wurden die Peakpositionen aus q = 2π/d = (4π/λ)sinθ berechnet, wobei q der Streuvektor ist. Der Detektor wurde in einer Scanning-Geometrie verwendet, die es ermöglichte, sämtliche Reihen gleichzeitig zu nutzen. Zur Reduktion des Hintergrundes wurde der divergente Strahl senkrecht zur Streuebene durch eine Maske von 4 mm kontrolliert, die die Breite des Strahls an der Probenposition auf etwa 10 mm begrenzt. Zusätzlich wurde die senkrechte Divergenz durch Sollerschlitze auf Winkel ≤ 2,3 ° begrenzt. Für jede neue Messung wurde die Höhe der (Pulver-)Probe optimiert. Die Scans wurden mit 2θ der Detektorachse durchgeführt, die sich mit der doppelten Geschwindigkeit der θ-Achse des einfallenden Strahls bewegt. Die Kalibrierung wurde mit einer Si-Referenzprobe überprüft. Die Auflösung des gesamten Aufbaus wurde durch die Messung eines hochwertigen Si-Wafers bestimmt, der einen auflösungsbegrenzten Peak mit einer Halbwertsbreite von 0,026 Grad ergab.

### III.2 Mechanische Messungen

Die Zugversuche wurden auf einem speziell angefertigten Laboraufbau, bestehend aus einem Mikromanipulator-Lineararm (MM33, Märzhäuser Wetzlar GmbH & Co. KG, Deutschland), einem Schrittmotor (NEMA 17, Stepperonline) und einer Hochpräzisionswaage (Mettler Toledo, Schweiz), durchgeführt. Die PEDOT:PSS Fasern wurden auf c-förmigen Papphaltern mit einem inneren Schenkelabstand von 10 mm fixiert. Die Papphalter garantierten eine definierte Anfangslänge der Fasern und verhinderten eine Dehnung vor den Zugtests. Die immobilisierten PEDOT:PSS-Fasern wurden anschließend 10 Sekunden lang in DI-Wasser getränkt, bevor der Papphalter über Klemmen am Lineararm und der Waage befestigt wurde. Schließlich wurden die Pappschenkel durch einen Schnitt getrennt und die PEDOT:PSS-Fasern mit einer Ziehgeschwindigkeit von 0,2 mm/s bis zum Versagen gedehnt. Dehnung und Masse wurden durch ein selbstgeschriebenes Python-Skript aufgezeichnet.

### III.3 Beschichtung mit ECM-Molekülen

Das Adsorptionsverhalten unterschiedlich geladener Polyelektrolyte (PE) an der Oberfläche von PEDOT:PSS-Partikeln wurde mit fluoresceinisothiocyanat (FITC)-markierten PEs untersucht. Positiv geladenes Poly-L-Lysin (PLL) (15.000 - 30.000 Da, Sigma Aldrich) und negativ geladenes Polystyrolsulfonat (PSS) (Surflay Nanotec GmbH) mit einem Markierungsgrad von 10 % wurden in 0,1 M Natriumchlorid (NaOH) wässrigen Lösungen in einer Konzentration von 1 mg/ml unter konstantem Rühren bei Raumtemperatur über Nacht gelöst. Anschließend wurden die PEDOT:PSS-Partikel in den jeweiligen PE-Lösungen für 5 Tage unter Lichtschutzbedingungen inkubiert. Abschließend wurden die Proben zweimal in einer 0,1 M NaOH wässrigen Lösung gespült und mit einem TCS SP8 Falcon Konfokalmikroskop (Leica, Deutschland) abgebildet. Für die Kultivierung von MRC-5 Zellen wurden PEDOT:PSS Partikel schichtweise mit PLL und Laminin (aus humaner Plazenta, Sigma Aldrich) beschichtet. Die Mikroträger wurden in 0,1 mg/ml PLL-Lösung auf einer Rollenvorrichtung bei Raumtemperatur für 24h inkubiert. Anschließend wurden die Proben in Milliq-Wasser gespült und in einer 40 µg/ml Laminin-Lösung auf einem Rollengerät bei 37 ° C für weitere 24 h inkubiert.

### III.4 Zellkultur

Zellpflege: L929 Mausfibroblast Zellen wurden in Roswell Park Memorial Institute (RPMI) 1640 Medium (4500 mg/L Glukose, L-Glutamin, Natriumpyruvat, Natriumbicarbonat) (Thermo Fisher Scientific) kultiviert, während MRC-5 humane embryonale fibroblast Zellen in Minimal Essential Medium (MEM) (1000 mg/L Glukose, 1X nicht-essentielle Aminosäuren, L-Glutamin, Natriumbicarbonat) (Sigma Aldrich) kultiviert wurden. Beide Zellkulturmedien wurden zusätzlich mit 10 % (v/v) fetalem Rinderserum (FBS) und 1 % (v/v) Penicillin/Streptomycin supplementiert. Die Zelllinien wurden bei 37°C in einer Atmosphäre von 5% CO₂ und einer Luftfeuchtigkeit von 95% gehalten. Die Passagezahl wurde unabhängig von der Zelllinie auf 30 Subkulturen beschränkt.

Die Zytotoxizität der Partikel wurde durch den Vergleich der Zellproliferation in frischem Medium mit der Zellproliferation in ausgelaugtem Medium unter Verwendung eines auf Tetrazoliumsalz basierenden Zellproliferations-Kits II (XTT) (Roche Diagnostics GmbH) am fünften und neunten Kulturtag bewertet. Das ausgelaugte Medium wurde durch Inkubation von niedrig- oder hochkristallinen PEDOT:PSS-Microcarriern in RPMI- und MEM-Medien für 5 Tage bei 37°C in einem Verhältnis von 10 Partikeln pro 100µl Medium hergestellt. Das ausgelaugte Medium wurde gesammelt und bis zur Verwendung bei 4°C gelagert. Die Zellen wurden in TC-behandelte Mikrotiterplatten (96 Wells, Corning Life Sciences) mit einer L929-Seeding-Konzentration von 1.500 Zellen pro Well und einer MRC-5-Seeding-Konzentration von 10.000 Zellen pro Well ausgesät. Anschließend wurden die Zellen über 9 Tage in frischem oder ausgelaugtem Medium gehalten, wobei alle 48 h ein Mediumwechsel durchgeführt wurde, um eine ausreichende Nährstoffversorgung zu gewährleisten. Für die Analyse der Zellviabilität wurden die zellbeinhaltenden Mikrotiterplatten mit PBS (1x) (Lonza, Schweiz) gewaschen, bevor sie für 4 h bei 37°C mit 150 µl XTT-Lösung beaufschlagt wurden. Anschließend wurden 100µl jeder Probe in eine frische TC-behandelte Mikrotiterplatte (96 Vertiefungen) überführt und die Absorption bei 450 und 630 nm mit einem Mikroplatten-Reader (Synergy HT, BioTek) gemessen. Die Zellviabilität wurde aus dem Verhältnis der Absorptionswerte von Zellen, die in ausgelaugtem Medium kultiviert wurden, zu Zellen, die in frischem Medium kultiviert wurden (Kontrolle), bestimmt.

Immunfärbung: Zur morphologischen Beurteilung wurden die Zellen für Kerne und F-Actin gefärbt, indem die Proben 5 min lang mit DAPI-Lösung (abcam, Großbritannien) und 60 min lang mit Phalloidin-iFluor 488-Reagenz (abcam, Großbritannien) behandelt wurden. Vor der Färbung wurden sämtliche Proben für 15 min in 4% (v/v) Paraformaldehyd (PFA)-Lösung fixiert, für 5 min in einer 0,1% (v/v) Triton X-100-Lösung permeabilisiert und gründlich in PBS (1x) gespült. Die visuelle Analyse der Zellviabilität wurde mit einem Live/Dead Cell Double Staining Kit (Sigma Aldrich) durchgeführt. Die Zellproben wurden einer sterilen PBS (1x)-Lösung mit 0,1% (v/v) Calcein-AM und 0,2% (v/v) Propidiumiodid für 30 min bei 37°C ausgesetzt.

Weitere Vorteile und vorteilhafte Ausgestaltungen der erfindungsgemäßen Gegenstände werden durch die Figuren veranschaulicht und in den nachfolgenden Beispielen erläutert. Dabei ist zu beachten, dass die Figuren nur beschreibenden Charakter haben und nicht dazu gedacht sind, die Erfindung in einer Form einzuschränken.

Es zeigen die Figuren:
- Figur 1: eine FeSEM Aufnahme eines erfindungsgemäß hergestellten, porösen PEDOT:PSS-Partikels;
- Figur 2: eine FeSEM Aufnahme eines erfindungsgemäß hergestellten, porösen PEDOT:PSS-Partikels mit Fibroblasten-Besiedelung;
- Figur 3: die gravimetrische Kapazität erfindungsgemäßer PEDOT:PSS-Partikel als Funktion der Porosität;
- Figur 4: die Abhängigkeit der Redox-Kinetik erfindungsgemäßer PEDOT:PSS-Partikel als Funktion der Porosität;
- Figur 5: die Abhängigkeit der Partikeldurchmesser erfindungsgemäßer PEDOT:PSS-Partikel als Funktion der Porosität;
- Figur 6: die Größenverteilung erfindungsgemäßer PEDOT:PSS-Partikel hergestellt mit einem Volumenanteil von 30 % an 1-Oktanol in der wässrigen PEDOT:PSS-Mischung;
- Figur 7: die Porengrößenverteilung erfindungsgemäßer PEDOT:PSS-Partikel hergestellt mit einem Volumenanteil von 30 % 1-Oktanol in der wässrigen PEDOT:PSS-Mischung.
- Figur 8: die Proliferation von L929-Zellen auf erfindungsgemäßen Partikeln als Funktion der Zeit und als Funktion der Kristallinität des Trägermaterials;
- Figur 9: den Einfluss der Kristallinität auf das Aspektverhältnis auf erfindungsgemäßen Partikeln proliferierender L929-Zellen;
- Figur 10: den Einfluss der Kristallinität erfindungsgemäßer Partikel auf die Ausbreitungsfläche von L929-Zellen.

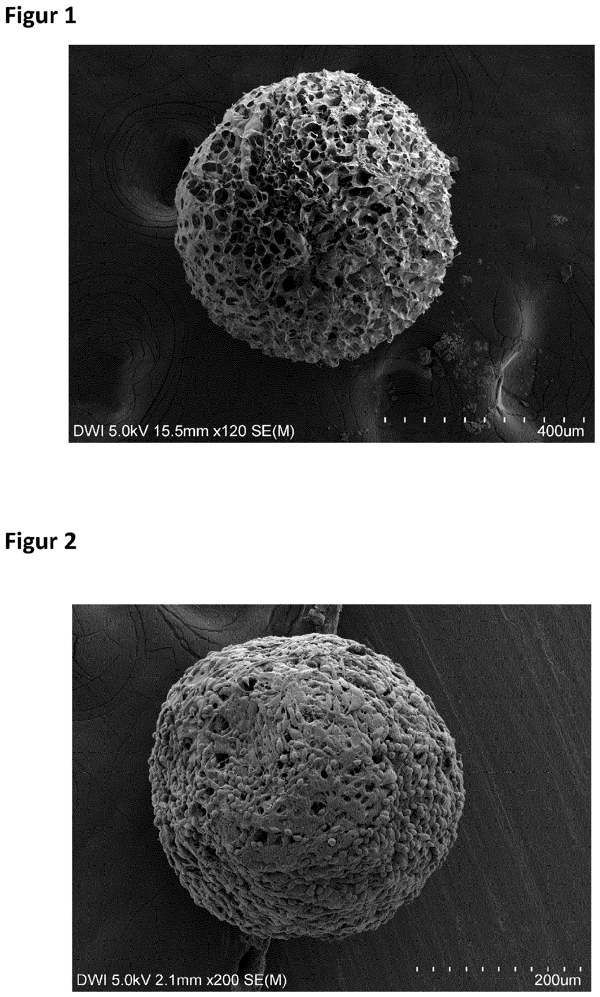

Die Figur 1 zeigt eine FeSEM Aufnahme eines erfindungsgemäß hergestellten, porösen PEDOT:PSS-Partikels. Der PEDOT:PSS-Partikel wurde mit einem 1-Oktanol Volumenanteil von 30% in der wässrigen PEDOT:PSS-Mischung hergestellt. Da PEDOT:PSS-Partikel Hydrogele darstellen und somit in wasserfreien Umgebungen kollabieren, wurde der Partikel vor der optischen Analyse gefriertrocknet.

Die Figur 2 zeigt eine FeSEM Aufnahme eines mit L929 Mäuse Fibroblasten besiedelten, porösen PEDOT:PSS-Partikels. Die Besiedlung des Mikroträgers ist nach 4 Tagen Kultivierung bei 37°C, 95% Luftfeuchtigkeit und 5% CO₂ gezeigt. Als Kulturmedium diente RPMI supplementiert mit 10% fetalem Kälberserum und 1% Penicillin-Streptomycin. Die Inokulationskonzentration betrug 10.000 Zellen/cm². Da PEDOT:PSS Partikel Hydrogele darstellen und somit in wasserfreien Umgebungen kollabieren, wurden der Partikel vor der optischen Analyse mit einer Ethanolreihe (35, 50, 70, 100%) und einer anschließenden Behandlung in Hexamethyldisilazan (HMDS) getrocknet.

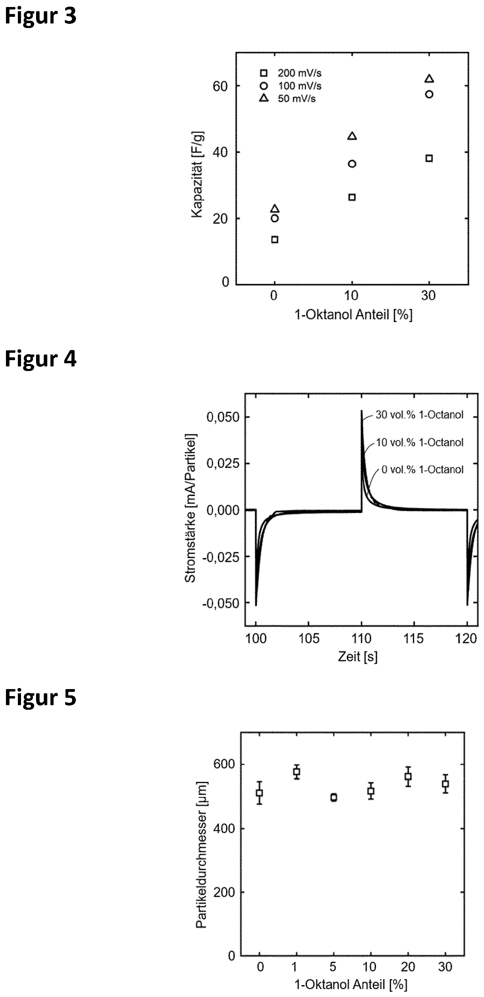

Die Figur 3 zeigt die gravimetrische elektrische Kapazität der PEDOT:PSS-Partikel in Abhängigkeit des 1-Oktanol Volumenanteils in der 1-Oktanol-PEDOT:PSS-Emulsion sowie in Abhängigkeit der Abtastrate. Höhere 1-Oktanol Anteile bezeichnen einen größeren Anteil Porenvolumen am Partikelvolumen (Porosität) und somit eine höhere spezifische Oberfläche. Die elektrischen Kapazitäten wurden aus Zyklovoltametriemessungen in einem 3-Elektroden-Setup in Abhängigkeit der Scanrate bestimmt. Da die spezifische Oberfläche der Partikel direkt proportional zur Partikelkapazität ist, zeigen porösere Partikel eine höhere gravimetrische Kapazität. Höhere Scanraten führen zu kleineren Kapazitäten, da das schnellere Durchlaufen der Spannungen dazu führt, dass nicht die komplette, zur Kapazität beitragende Oberfläche des Partikels genutzt wird.

Die Figur 4 zeigt den Stromverlauf als Funktion der Zeit. Die Erfassung der Redox-Kinetik der PEDOT:PSS Partikel wurde mittels Chronoamperometriemessungen in Abhängigkeit des Volumenanteils an 1-Oktanol und somit der Porosität in einem 3-Elektroden Setup durchgeführt. Die Reaktionszeit der Partikel verkürzt sich mit zunehmender Porosität, obwohl sich die Ladungsdichte mit zunehmender Porosität erhöht. Die verkürzte Reaktionszeit wird der hohen spezifischen Oberfläche sowie der guten Zugänglichkeit des Porensystems zugeschrieben, welche eine schnelle Redoxkinetik ermöglicht. Die Messungen wurden über 9 Zyklen durchgeführt, wobei nur ein Zyklus im Diagramm dargestellt ist.

Die Figur 5 zeigt den durchschnittlichen Partikeldurchmesser in Abhängigkeit des 1-Oktanol Volumenanteils in der 1-Oktanol-PEDOT:PSS-Emulsion als Maß für die Partikelporosität. Sämtliche im Diagramm gezeigten Partikel wurden mit einer 1-Oktanol Flussrate (kontinuierliche Phase) von 0,5 mL/min sowie einer PEDOT:PSS-Dispersions-/Emulsions-Flussrate von 0,05 mL/min hergestellt. Die Partikel weisen unabhängig von der Partikelporosität einen Partikeldurchmesser von ca. 540 µm auf. Die geringe Standardabweichung des Partikeldurchmessers rührt wahrscheinlich daher, dass die Tropfen im Co-Flow device monodisperse erzeugt werden. Kleinere Variationen im Partikeldurchmesser kommen durch eine sehr geringe unterschiedliche Abtrennungskinetik der schützenden 1-Oktanolhülle im Koagulationsbad zustande.

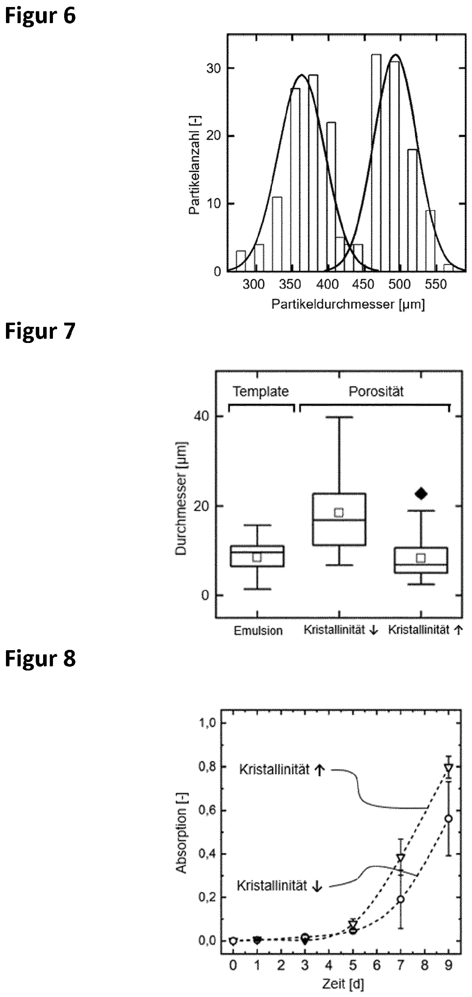

Die Figur 6 zeigt die Größenverteilung hoch- (links) und niedrig- (rechts) kristalliner PEDOT:PSS-Partikel hergestellt mit einem Volumenanteil an 1-Oktanol von 30% in der wässrigen PEDOT:PSS-Mischung. Es ergibt sich für beide Fälle eine eher enge Partikel-Größenverteilung.

Die Figur 7 zeigt die Porogen- und Porengrößenverteilungen für hoch- und niedrig-kristalline, poröse PEDOT:PSS-Partikel, welche mit einem Volumenanteil an 1-Oktanol von 30% hergestellt wurden. Die meisten Poren weisen eine Größe zwischen 15 und 20 µm auf. Über 90% der Poren zeigen eine Porengröße zwischen 10 und 30 µm.

Die Figuren 8-10 zeigen die Ergebnisse in der Zellbesiedlung erfindungsgemäßer Partikel. Für die Kulturexperimente wurden sphärische PEDOT:PSS- Partikel aus einer 30 vol.% 1-Oktanol in PEDOT:PSS (1.1-1,3 Gew.-%) Emulsion hergestellt, welche in einer kontinuierlichen 1-Oktanol Phase zum Tropfenabriss gebracht wurde. Die Emulsion wurde über einen Ultraschall-Homogenisierer (Hierschler UP100H) erhalten. Beide Phasen wurden über eine Spritzenpumpe (Chemyx, Nexus Fusion 4000) mit jeweils einer Flussrate von 0,05 und 0,5 ml/min zusammengeben. Das Koagulationsbad bestand soweit nicht anders angegeben aus 5 Vol.-% Schwefelsäure in Isopropanol.

Die Figur 8 zeigt die Ergebnisse der Proliferation von L929-Zellen auf erfindungsgemäßen Partikeln als Funktion der Zeit und als Funktion der Kristallinität des Trägermaterials. Mittels unterschiedlicher Koagulation mit unterschiedlichen Säuremengen wurden poröse Partikel mit einem unterschiedlichen Kristallinitätsgrad hergestellt. Die niedrig-kristallinen wurden mit 5 Vol.-% und die hoch-kristallinen Partikel wurden mit 95 Vol.-% Schwefelsäure koaguliert. Es ergeben sich Partikel mit unterschiedlichen mechanischen Eigenschaften. Die Eigenschaften ergeben sich wie folgt:

| Kristallinität | E-Modul in MPa | Bruchlast in kPa | Bruchdehnung % |
|---|---|---|---|
| Hoch | 0,07 | 28 (+/- 13) | 36 (+/- 6) |
| Niedrig | 9,85 | 626 (+/- 32) | 13 (+/- 6) |

Die unterschiedlichen mechanischen Eigenschaften sind ein starkes Indiz, dass die Struktur der beiden Proben, trotz gleicher Zusammensetzung, unterschiedlich ist. Diese unterschiedlichen Eigenschaften der sphärischen Partikel führen auch zu Änderungen in den biologischen Eigenschaften. Die Figur 8 zeigt die Ergebnisse der Zellproliferation von L929 Mausfibroblasten mit einer Aussaatdichte von 2.600 Zellen/cm², N = 5 auf reinen PEDOT:PSS Mikroträgern, wobei die Vitalität anhand eines XTT-Proliferations-Assay quantitativ bestimmt wurde. Es lässt sich deutlich erkennen, dass die Kristallinität des Trägermaterials einen Einfluss auf die Zellproliferation hat. Die Proliferation ab dem Tag 5 ist auf hoch kristallinen Proben (Dreiecke) deutlich höher als auf niedrig kristallinen Proben (Kreise).

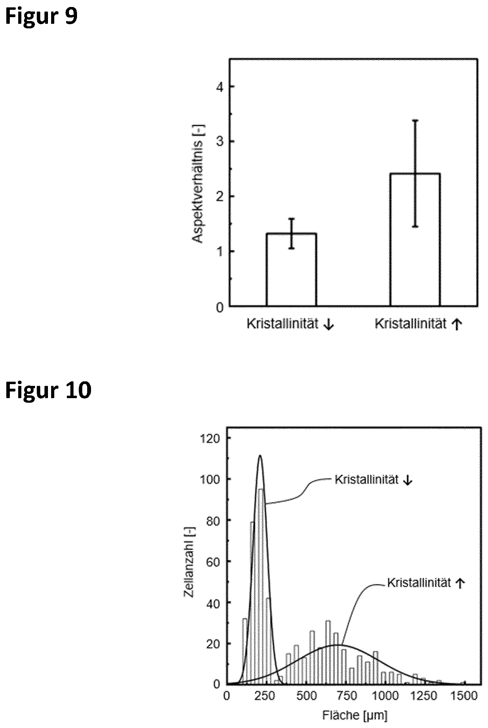

Die Figur 9 zeigt den Einfluss der Kristallinität auf das Aspektverhältnis auf erfindungsgemäßen Partikel proliferierender L929-Zellen. Der Kristallinitätsgrad der Partikel scheint auch einen Einfluss auf die erreichbare Morphologie der eingesetzten Zelllinien zu haben. Mittel konfokaler Mikroskopie lassen sich mittels DAPI/Phalloidin-gefärbte L929-Zellen morphologisch beurteilen. Eine Möglichkeit zur Darstellung der Zellsymmetrie ist die Bestimmung des Aspektverhältnisses der L929-Zellen. Man findet auf niedrig und hoch kristallinen Partikeln unterschiedliche Zellmorphologien, wobei bei eher geringer Kristallinität sich eher runde und bei hoch kristallinen Partikeln sich eher elongierte Zellmorphologien einstellen. Die Aussaatdichte betrug 2.600 Zellen/cm², die Messung wurde am zweiten Tag an 250 Zellen durchgeführt.

Die Figur 10 zeigt den Einfluss der Kristallinität erfindungsgemäßer Partikel auf die Ausbreitungsfläche von L929-Zellen. Die unterschiedlichen Kristallinitätsgrade der Partikel wurden über eine unterschiedliche Koagulationsbehandlung sphärischer Partikel erhalten. Es lässt sich erkennen, dass eine einzelne L929-Zelle auf kristallinen Partikeln eine deutlich größere Fläche besiedelt. Die Ausbreitung der Zellen auf Partikeln mit geringer Kristallinität ist hingegen deutlich eingeschränkter. Des Weiteren ergibt sich, dass die Zellen auf Partikeln mit geringer Kristallinität wahrscheinlich tiefer in das Partikelinnere proliferieren. Die Besiedelungsdichte im Inneren der Partikel schein bei hoch kristallinen Partikeln dagegen reduziert zu sein.

## Patentansprüche

1. Verfahren zur Herstellung von Poly(3,4-ethylendioxythiophen):Polystyrolsulfonat (PEDOT:PSS) Partikeln mindestens umfassend die Schritte:
a) Bereitstellen einer Mischung umfassend Poly(3,4-ethylendioxythiophen) und Polystyrol-sulfonat in einem Lösemittel mindestens umfassend Wasser;
b) Ausbilden eines oder mehrerer PEDOT:PSS-Tropfen durch Einbringen der Mischung aus Verfahrensschritt a) in ein organisches Lösemittel A, wobei die wässrige PEDOT:PSS-Mischung das Tropfeninnere und das organische Lösungsmittel A das Tropfenäußere ausbilden;
c) Kontaktieren der PEDOT:PSS-Tropfen erhalten aus Verfahrensschritt b) mit einer Koagulierlösung umfassend ein Aushärtungsmittel und mindestens ein weiteres Lösungsmittel B, wobei die Dichte der Koagulierlösung größer als die Dichte des organischen Lösemittels A und kleiner als die Dichte der wässrigen Poly(3,4-ethylendioxythiophen) und Polystyrolsulfonat-Mischung ist; unter Aushärten der PEDOT:PSS-Tropfen zu PEDOT:PSS-Partikeln.

2. Verfahren nach Anspruch 1, wobei das organische Lösemittel A ausgesucht ist aus der Gruppe bestehend aus verzweigten oder unverzweigten C5-C10 Alkanen, verzweigten oder unverzweigten C5-C10 Alkoholen oder Mischungen mindestens zweier Lösemittel daraus.

3. Verfahren nach einem der vorhergehenden Ansprüche, wobei das weitere Lösemittel B ausgesucht ist aus der Gruppe bestehend aus verzweigten oder unverzweigten C1-C5 Alkoholen oder Mischungen mindestens zweier Lösemittel daraus.

4. Verfahren nach einem der vorhergehenden Ansprüche, wobei das Lösemittel A Oktanol und die Koagulierlösung im Verfahrensschritt c) Isopropanol als Lösemittel B und Schwefelsäure als Aushärtungsmittel umfasst.

5. Verfahren nach einem der vorhergehenden Ansprüche, wobei das Gewichtsverhältnis von Aushärtungsmittel und Lösemittel B in der Koagulierlösung, ausgedrückt als Gewicht Aushärtungsmittel dividiert durch Gewicht Lösemittel B, größer oder gleich 0,005 und kleiner oder gleich 0,2 beträgt.

6. Verfahren nach einem der vorhergehenden Ansprüche, wobei die PEDOT:PSS-Mischung im Verfahrensschritt a) keine weiteren mechanisch verfestigenden Substanzen aufweist.

7. Verfahren nach einem der vorhergehenden Ansprüche, wobei die PEDOT:PSS-Mischung im Verfahrensschritt a) neben Wasser als weitere Lösemittelkomponente ein organisches Lösemittel A aufweist.

8. Poly(3,4-ethylendioxythiophen)-Polystyrolsulfonat Partikel, **dadurch gekennzeichnet, dass** die Partikel nach einem Verfahren nach einem der Ansprüche 1-7 hergestellt sind.

9. Partikel nach Anspruch 8, wobei die Partikel sphärisch ausgebildet sind und neben PEDOT:PSS keine weiteren mechanisch verfestigenden Substanzen aufweisen.

10. Partikel einem der Ansprüche 8 oder 9, wobei der Partikel ein Elastizitätsmodul von größer oder gleich 0,05 MPa und kleiner oder gleich 15 MPa aufweist.

11. Partikel nach einem der Ansprüche 8 - 10, wobei der Partikel zumindest teilkristallin mit Bragg-Reflexen in einem XRD-Spektrum bei 4,3 (+- 0,2) nm⁻¹ und 18,4 (+-0,2) nm⁻¹ ist.

12. Partikel nach einem der Ansprüche 8 - 11, wobei die Oberfläche des Partikels ein Zeta-potential von kleiner oder gleich 0 mV aufweist.

13. Verwendung der Partikel nach einem der Ansprüche 8 - 12 ausgesucht aus der Gruppe bestehend aus Zellkultur-Mikroträgern, Suspensionselektroden, schaltbares Redox-Absorbermaterial, Katalysatorträger oder Kombinationen daraus.

14. Verwendung nach Anspruch 13, wobei die Partikel als Zellkultur-Mikroträger verwendet werden, wobei die Oberfläche der Partikel vor der Kultivierung mit einer oder mehreren Molekülen ausgewählt aus der Gruppe bestehend aus Poly-L-Lysin, Laminin, Kollagen, Fibronektin, Vitronektin oder Mischungen daraus beschichtet werden.

15. Verwendung nach Anspruch 14, wobei die Oberfläche der Partikel zuerst mit Poly-L-Lysin und anschließend mit Laminin beschichtet werden.

## Claims

1. A method for producing poly(3,4-ethylenedioxythiophene) polystyrene sulfonate (PEDOT:PSS) particles comprising at least the steps of:
a) providing a mixture comprising poly(3,4-ethylenedioxythiophene) and polystyrene sulfonate in a solvent comprising at least water;
b) forming one or more PEDOT:PSS drops by introducing the mixture from method step a) into an organic solvent A, the aqueous PEDOT:PSS mixture forming the interior of the drop and the organic solvent A forming the exterior of the drop;
c) contacting the PEDOT:PSS drops obtained from step b) with a coagulation solution comprising a curing agent and at least one further solvent B, wherein the density of the coagulating solution is greater than the density of the organic solvent A and less than the density of the aqueous poly(3,4-ethylenedioxythiophene) and polystyrene sulfonate mixture; thereby curing the PEDOT:PSS drops into PEDOT:PSS particles.

2. The method according to claim 1, wherein the organic solvent A is selected from the group consisting of branched or unbranched C5-C10 alkanes, branched or unbranched C5-C10 alcohols or mixtures of at least two solvents therefrom.

3. The method according to any one of the preceding claims, wherein the further solvent B is selected from the group consisting of branched or unbranched C1-C5 alcohols or mixtures of at least two solvents therefrom.

4. The method according to any one of the preceding claims, wherein the solvent A comprises octanol and the coagulating solution in process step c) comprises isopropanol as the solvent B and sulfuric acid as curing agent.

5. The method according to any one of the preceding claims, wherein the weight ratio of the curing agent and solvent B in the coagulating solution, expressed as the weight of the curing agent divided by the weight of solvent B, is greater than or equal to 0.005 and less than or equal to 0.2.

6. The method according to any one of the preceding claims, wherein the PEDOT:PSS mixture in method step a) has no further mechanically strengthening substances.

7. The method according to any one of the preceding claims, wherein the PEDOT:PSS mixture in method step a) has an organic solvent A, in addition to water as a further solvent component.

8. Poly(3,4-ethylenedioxythiophene) polystyrene sulfonate particles, **characterised in that** the particles are produced by a method according to any one of claims 1-7.

9. Particles according to claim 8, wherein the particles are spherical and do not contain any further mechanically strengthening substances besides PEDOT:PSS.

10. Particles according to any one of claims 8 or 9, wherein the particle has a modulus of elasticity greater than or equal to 0.05 MPa and less than or equal to 15 MPa.

11. Particle according to any one of claims 8-10, wherein the particle is at least partially crystalline with Bragg reflections in an XRD spectrum at 4.3 (+- 0.2) nm⁻¹ and 18.4 (+- 0.2) nm⁻¹.

12. Particles according to any one of claims 8-11, wherein the surface of the particle has a zeta potential of less than or equal to 0 mV.

13. Use of the particles according to any one of claims 8-12 selected from the group consisting of cell culture microcarriers, suspension electrodes, switchable redox absorber material, catalyst carriers or combinations thereof.

14. Use according to claim 13, wherein the particles are used as cell culture microcarriers, wherein the surface of the particles being coated prior to culturing with one or more molecules selected from the group consisting of poly-L-lysine, laminin, collagen, fibronectin, vitronectin or mixtures thereof.

15. Use according to claim 14, wherein the surface of the particles is first coated with poly-L-lysine and then with laminin.

## Revendications

1. Procédé de production de particules de poly(3,4-éthylènedioxythiophène) polystyrène sulfonate (PEDOT:PSS) comprenant au moins les étapes suivantes :
a) fourniture d'un mélange comprenant du poly(3,4-éthylènedioxythiophène) et du polystyrène sulfonate dans un solvant comprenant au moins de l'eau ;
b) formation d'une ou de plusieurs gouttes de PEDOT:PSS en introduisant le mélange de l'étape a) du procédé dans un solvant organique A, le mélange aqueux de PEDOT:PSS formant l'intérieur de la goutte et le solvant organique A formant l'extérieur de la goutte ;
c) mise en contact des gouttes de PEDOT:PSS obtenues à l'étape b) avec une solution de coagulation comprenant un agent de durcissement et au moins un autre solvant B, la densité de la solution de coagulation étant supérieure à la densité du solvant organique A et inférieure à la densité du mélange aqueux de poly(3,4-éthylènedioxythiophène) et de polystyrène sulfonate ; permettant ainsi de durcir les gouttes de PEDOT:PSS en particules de PEDOT:PSS.

2. Procédé selon la revendication 1, dans lequel le solvant organique A est choisi dans le groupe constitué par des alcanes C5-C10 ramifiés ou non ramifiés, des alcools C5-C10 ramifiés ou non ramifiés ou des mélanges d'au moins deux solvants parmi ceux-ci.

3. Procédé selon l'une quelconque des revendications précédentes, dans lequel le solvant organique B suivant est choisi dans le groupe constitué par des alcools C1-C5 ramifiés ou non ramifiés ou des mélanges d'au moins deux solvants parmi ceux-ci.

4. Procédé selon l'une quelconque des revendications précédentes, dans lequel le solvant A comprend de l'octanol et la solution de coagulation dans l'étape c) du procédé comprend de l'isopropanol comme solvant B et de l'acide sulfurique comme agent de durcissement.

5. Procédé selon l'une quelconque des revendications précédentes, dans lequel le rapport pondéral de l'agent de durcissement et du solvant B dans la solution de coagulation, exprimé en poids d'agent de durcissement divisé par le poids du solvant B, est supérieur ou égal à 0,005 et inférieur ou égal à 0,2.

6. Procédé selon l'une quelconque des revendications précédentes, dans lequel le mélange de PEDOT:PSS de l'étape a) du procédé ne contient pas d'autres substances de consolidation mécanique.

7. Procédé selon l'une quelconque des revendications précédentes, dans lequel le mélange de PEDOT:PSS dans l'étape a) du procédé contient un solvant organique A, en plus de l'eau comme autre composant de solvant.

8. Particules de poly(3,4-éthylènedioxythiophène) polystyrène sulfonate, **caractérisées en ce que** les particules sont produites par un procédé selon l'une des revendications 1 à 7.

9. Particules selon la revendication 8, dans lesquelles les particules sont sphériques et ne contiennent aucune autre substance de renforcement mécanique en plus du PEDOT:PSS.

10. Particules selon l'une des revendications 8 ou 9, dans lesquelles la particule présente un module d'élasticité supérieur ou égal à 0,05 MPa et inférieur ou égal à 15 MPa.

11. Particule selon l'une des revendications 8 à 10, dans laquelle la particule est au moins partiellement cristalline avec des réflexions de Bragg dans un spectre XRD à 4,3 (+- 0,2) nm⁻¹ et 18,4 (+- 0,2) nm⁻¹.

12. Particules selon l'une des revendications 8 à 11, dans lesquelles la surface de la particule a un potentiel zêta inférieur ou égal à 0 mV.

13. Utilisation des particules selon l'une des revendications 8 à 12 choisies dans le groupe constitué par des microsupports de culture cellulaire, des électrodes de suspension, un matériau absorbant redox commutable, des supports de catalyseur ou des combinaisons de ceux-ci.

14. Utilisation selon la revendication 13, dans laquelle les particules sont utilisées comme microsupports de culture cellulaire, la surface des particules étant revêtue avant la culture avec une ou plusieurs molécules choisies dans le groupe constitué par la poly-L-lysine, la laminine, le collagène, la fibronectine, la vitronectine ou leurs mélanges.

15. Utilisation selon la revendication 14, dans laquelle la surface des particules est d'abord revêtue de poly-L-lysine puis de laminine.
